# EUROPÄISCHE PATENTSCHRIFT

(11) **EP 1 608 908 B1**
(45) Veröffentlichungstag und Bekanntmachung des Hinweises auf die Patenterteilung: **02.11.2006**
(21) Anmeldenummer: 04725623.5
(22) Anmeldetag: 03.04.2004
(51) Int. Cl.: F21S 8/10

(54) **SCHEINWERFER FÜR FAHRZEUGE**
VEHICLE HEADLAMP
PHARE DE VEHICULE

(30) Priorität: 03.04.2003 DE 10315131
(43) Veröffentlichungstag der Anmeldung: 28.12.2005
(73) Patentinhaber: Hella KGaA Hueck & Co., 59552 Lippstadt (DE)
(72) Erfinder: EICHHORN, Karsten, 59320 Ennigerloh (DE); HAGEDORN, Susanne, 59558 Lippstadt (DE); LÜDER, Christian, 33729 Bielefeld (DE); WÜLLER, Martin, 48231 Warendorf (DE)
(86) Internationale Anmeldenummer: PCT/EP2004/003565
(87) Internationale Veröffentlichungsnummer: WO 2004/088201

(56) Entgegenhaltungen:
- EP-A- 1 270 324
- DE-A- 10 009 782
- DE-A- 10 025 563
- US-B1- 6 530 679

## Beschreibung

Die Erfindung betrifft einen Scheinwerfer für Fahrzeuge mit mindestens einem eine Mehrzahl von Leuchtelementen-Chips aufweisenden flächenhaften Leuchtfeld und mit einem sich im Strahlengang des von dem Leuchtfeld ausgesandten Lichtbündels angeordneten Optikelement.

Aus der DE 100 09 782 A1 ist ein Scheinwerfer für Fahrzeuge bekannt, in dem eine Mehrzahl von Leuchtelementen-Chips in Form einer Matrix angeordnet sind. Zur Erzeugung von unterschiedlichen Lichtfunktionen kann eine Gruppe von unterschiedlichen Leuchtelementen-Chips angesteuert werden, so dass eine vorgegebene Leuchtdichteverteilung in Verbindung mit einem dem Leuchtfeld vorgelagerten Optikelement erzeugt werden kann.

Auch aus der EP 1 270 324 A2 ist ein Scheinwerfer für Fahrzeuge mit einer Mehrzahl von Leuchtelementen-Chips bekannt, wobei unterschiedliche Gruppen von Leuchtelementen-Chips ansteuerbar sind zur Erzeugung von unterschiedlichen Lichtfunktionen. Die Mehrzahl von Leuchtelementen-Chips bilden ein flächenhaftes Leuchtfeld, das ein Lichtbündel in Lichtabstrahlungsrichtung zu einem als Sammellinse ausgebildeten Optikelement aussendet. Das Optikelement sammelt das von dem Leuchtfeld ausgesandte Lichtbündel entsprechend einer vorgegebenen Leuchtdichteverteilung.

Bei den bekannten Scheinwerfern ist das flächenhafte Leuchtfeld durch ein zweidimensionales Array gebildet, in dem die Leuchtelemente-Chips dicht gepackt und regelmäßig zusammengefasst sind.

Aufgabe der vorliegenden Erfindung ist es, einen Scheinwerfer für Fahrzeuge derart weiterzubilden, dass zum einen ein platzsparender und kompakter Aufbau gewährleistet ist und zum anderen die Effektivität des Scheinwerfer erhöht Wird.

Zur Lösung dieser Aufgabe ist die Erfindung in Verbindung mit dem Oberbegriff des Patentanspruchs 1 dadurch gekennzeichnet, dass die Leuchtelemente-Chips des Leuchtfeldes in einer gemeinsamen Ausnehmung angeordnet sind und dass die Ausnehmung auf einer in Lichtabstrahlrichtung zugewandten Seite eine Randkante derart in räumlicher Anordnung zu den Leuchtelementen-Chips aufweist, dass ein vorgegebener Leuchtdichtegradient in einer Leuchtdichteverteilung des Scheinwerfers im Bereich der Randkanten ausgebildet wird.

Vorteilhaft ermöglicht die Erfindung durch eine gewählte räumlich in Beziehung zu den Leuchtelementen-Chips stehende Randkante eines Leuchtfeldes die Ausbildung einer relativ scharfen Hell-Dunkel-Grenze in der Leuchtdichteverteilung des Scheinwerfers. Grundgedanke der Erfindung ist es, eine Mehrzahl von Leuchtelementen-Chips in räumliche Anordnung zu einer Randkante zu positionieren, so dass in einer Leuchtdichteverteilung entlang einer Linie senkrecht zur Randkante ein steiler Leuchtdichtegradient gebildet ist. Hierdurch kann in Verbindung mit dem vorgelagerten Optikelement eine wesentlich verbessert ausgebildete Hell-Dunkel-Grenze erzeugt werden.

Nach einer bevorzugten Ausführungsform der Erfindung ist die Ausnehmung zur Aufnahme der Leuchtelement-Chips wannenförmig ausgebildet, wobei die Randkante durch das freie Ende einer sich von einer Basisseite des Leuchtfeldes erstreckenden Randwandung gebildet ist. Vorteilhaft kann die Ausnehmung als gemeinsames Gehäuse für die Mehrzahl von Leuchtelementen-Chips dienen, wobei durch gezielte relative räumliche Anordnung von einem Teil der Leuchtelemente-Chips zu der Randkante die Bildung einer scharfen Hell-Dunkel-Grenze maßgeblich gefördert wird.

Nach einer Weiterbildung der Erfindung ist die Form der Ausnehmung bzw. der Verlauf der Randkante bzw. der Randwandung der Ausnehmung auf die zu erzeugende Leuchtdichteverteilung abgestimmt. Die Form der Ausnehmung bzw. der Randkante prägt somit die Leuchtdichteverteilung, wobei beispielsweise mittels einer mit einem Knick versehenen Randkante eine asymmetrische Leuchtdichteverteilung erzeugt werden kann.

Nach einer Weiterbildung der Erfindung ist die Ausnehmung mit einem lichtkonvertierenden Leuchtstoff aufgefüllt, so dass das von den Leuchtelementen-Chips ausgesandte Licht in weißes Licht umgewandelt wird. Vorteilhaft ist der Leuchtstoff in einem Vergussmaterial integriert angeordnet, so dass platzsparend zum einen eine Lichtkonversion und zum anderen eine mechanische Schutzabdeckung der Leuchtelementen-Chips gegeben ist.

Nach einer Weiterbildung der Erfindung ist eine Bodenfläche der Ausnehmung verspiegelt ausgebildet, so dass eine Leuchteffizienzsteigerung gegeben ist und zum anderen die Steilheit der Leuchtdichtegradienten in gewünschter Weise beeinflusst werden kann.

Weitere Vorteile der Erfindung ergeben sich aus den weiteren Unteransprüchen.

Ausführungsbeispiele der Erfindung werden nachfolgend anhand der Zeichnungen näher erläutert.

Es zeigen:
- Figur 1a: eine schematische Perspektivansicht einer ersten Ausführungsform der Erfindung,
- Figur 1b: eine Lichtverteilung des Scheinwerfers gemäß Figur 1a,
- Figur 2: eine perspektivische Darstellung einer die Mehrzahl von Leuchtelementen-Chips aufweisenden Leuchtplatte des Scheinwerfer gemäß Figur 1a,
- Figur 3: einen Schnitt entlang der Linie III-III gemäß Figur 2,
- Figur 4a: eine Draufsicht auf ein Leuchtfeld des Scheinwerfers gemäß Figur 1a bzw. auf eine Leuchtplatte des Scheinwerfers gemäß Figur 2,
- Figur 4b: eine Leuchtdichteverteilung des Leuchtfeldes gemäß Figur 4a entlang der Linien a und b,
- Figur 5a: eine schematische Perspektivansicht eines Scheinwerfers nach einer zweiten Ausführungsform,
- Figur 5b: eine Lichtverteilung des Scheinwerfer gemäß Figur 5a,
- Figur 6a: eine Draufsicht auf ein Leuchtfeld des Scheinwerfers gemäß Figur 5a,
- Figur 6b: eine Leuchtdichteverteilung des Leuchtfeldes gemäß Figur 6a entlang der Linien a und b,
- Figur 7a: eine schematische Perspektivansicht eines Scheinwerfers nach einer dritten Ausführungsform,
- Figur 7b: eine Lichtverteilung des Leuchtfeldes gemäß Figur 7a entlang der Linien a und b,
- Figur 8a: eine Draufsicht auf ein Leuchtfeld des Scheinwerfers gemäß Figur 7a und
- Figur 8b: eine Leuchtdichteverteilung des Leuchtfeldes gemäß Figur 8a entlang der Linien a und b.

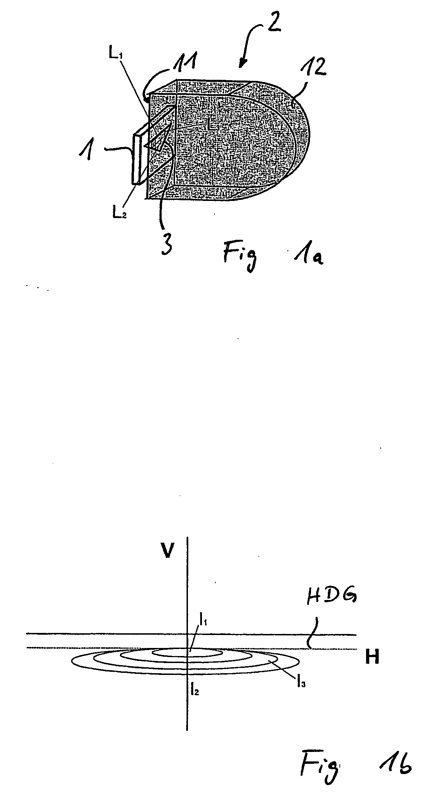

Ein Scheinwerfer für Fahrzeuge gemäß einer ersten Ausführungsform nach Figur 1a bis Figur 4b besteht im wesentlichen aus einer Leuchtplatte 1 und einem Optikelement 2, die in herkömmlicher Art und Weise in einem nicht dargestellten Scheinwerfergehäuse befestigt sind. Alternativ können auch mehrere Leuchtplatten 1 vorgesehen sein, die in Kombination eine gemeinsame Lichtverteilung ergeben.

Die Leuchtplatte 1 weist ein dreieckförmiges Leuchtfeld 3 auf, in dem eine Mehrzahl von Leuchtelementen-Chips 4 angeordnet sind.

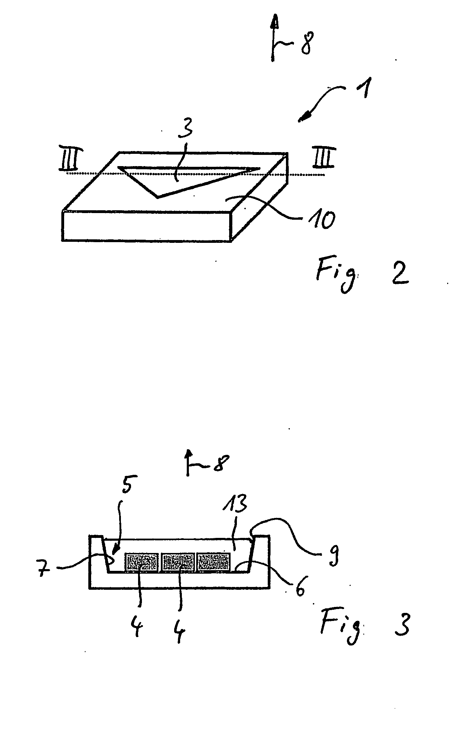

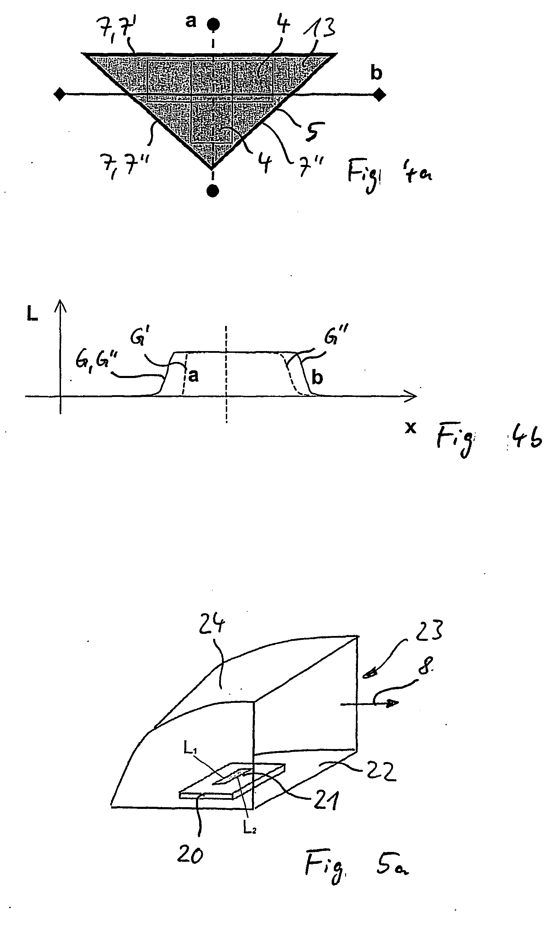

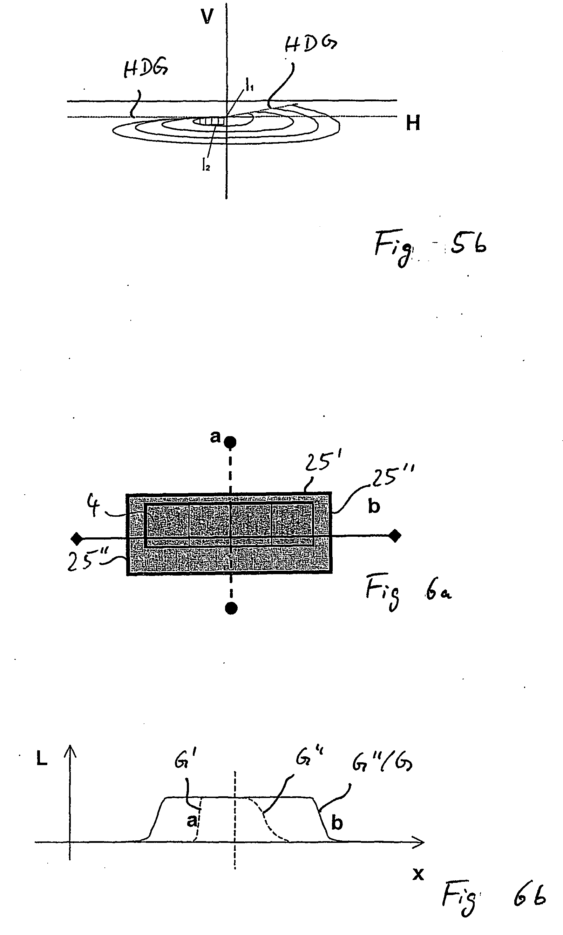

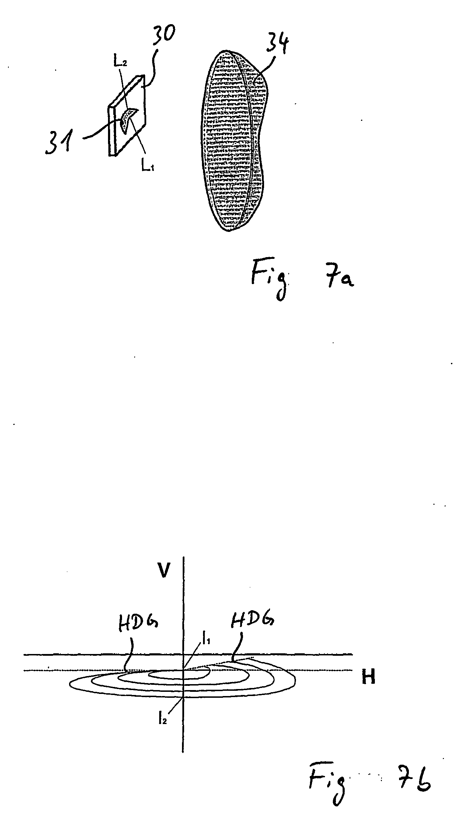

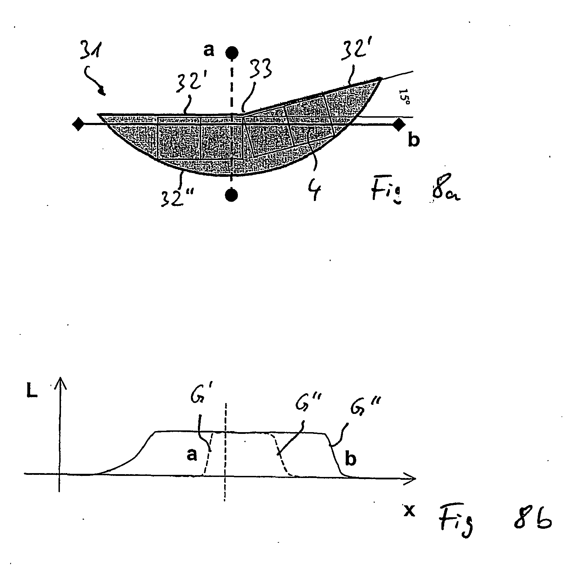

Wie besser aus den Figuren 2 und 3 zu ersehen ist, weist die Leuchtplatte 1 eine Ausnehmung 5 auf, an deren Bodenfläche 6 die Leuchtelemente-Chips 4 befestigt sind. Die Ausnehmung 5 ist als Wanne ausgebildet, wobei sich von der Bodenseite 6 randseitig aufrechte Randwandungen 7 in Richtung einer Lichtabstrahlrichtung 8 des Leuchtfeldes 3 erstrecken. Das freie Ende der Randwandung 7 bildet eine Randkante 9, von der aus sich eine die Ausnehmung 5 begrenzende Vorderseite 10 der Leuchtplatte 1 in einer Ebene erstreckt. Die Leuchtplatte 1 ist quaderförmig ausgebildet.

Die Bodenseite 6 kann verspiegelt ausgebildet sein, damit die Leuchtdichteverteilung verbessert wird.

Wie aus Figur 1a deutlich wird, liegt die Leuchtplatte 1 mit der Vorderseite 10 an einer Lichteinkoppelfläche 11 des Optikelementes 2 an.

Das Optikelement 2 dient als Lichtleitelement und weist in Lichtabstrahlrichtung 8 eine konvexförmige Lichtaustrittsfläche 12 auf.

In Figur 1b ist die Lichtverteilung dieses Scheinwerfers dargestellt, wobei unterschiedliche Bereiche L₁, L₂, L₃ des Leuchtfeldes 3 für unterschiedliche Intensitäten I₁, I₂, I₃ der Leuchtdichteverteilung verantwortlich sind.

Wie insbesondere aus den Figuren 4a und 4b deutlich wird, sind die Leuchtelemente-Chips 4 in der in Draufsicht dreieckförmigen Ausnehmung 5 ebenfalls in dreieckförmiger Anordnung positioniert, wobei der Abstand der einer bevorzugten Randwandung 7' der dreieckförmigen Ausnehmung 5 zugewandten Leuchtelemente-Chips 4 zu der Randwandung 7' gering ist. Vorzugsweise liegen diese Leuchtelemente-Chips 4 unmittelbar an der entsprechenden Randwandung 7' an. Der Zwischenraum zwischen den Leuchtelemente-Chips 4 und den anderen Randwandungen 7" ist ausgefüllt durch einen Füllstoff mit einem lichtsammelnden oder lichtkonvertierenden Zusatzmaterial. Vorzugsweise sind die Leuchtelemente-Chips 4 vollständig von einem Vergussmaterial 13 überdeckt, das sich von der Bodenseite 6 bis zu einer Ebene erstreckt, in der die Vorderseite 10 verläuft. Das Vergussmaterial 13 weist insbesondere einen lichtkonvertierenden Leuchtstoff auf, mittels dessen das an sich von den Leuchtelementen-Chips 4 emittierte blaue Licht durch additive Farbmischung in weißes Licht konvertiert wird.

Die Leuchtelemente-Chips können als Volumenstrahler ausgebildet sein mit der Größe von 1 mm². Die Leuchtelemente-Chips 4 sind derart aufgebaut, dass sie in seitlicher Richtung, dass heißt senkrecht zur Hauptabstrahlrichtung, Licht aussenden können. Die Leuchtelemente-Chips 4 sind vorzugsweise als Leuchtdioden-Chips (LED-Chips) ausgebildet.

Wie aus der Leuchtdichteverteilung L entlang der Linien a und b gemäß Figur 4b deutlich wird, wirkt sich der seitliche Abstand der Leuchtelemente-Chips 4 zu den jeweiligen Randwandungen 7, 7', 7" maßgeblich auf den Verlauf eines Leuchtdichtegradienten G aus. Ein Gradient G' im Bereich der bevorzugten Randwandung 7' ist relativ groß ausgebildet, dass heißt die Leuchtdichteverteilung weist in diesem Bereich einen steilen Anstieg auf, so dass in Verbindung mit dem Optikelement 2 eine relativ scharfe Hell-Dunkel-Grenze HDG erzielt werden kann. Die anderen Übergänge in den Bereichen der Randwandung 7" weisen einen kleineren Leuchtdichtegradienten G" auf.

Nach einer zweiten Ausführungsform eines Scheinwerfer gemäß Figur 5a bis 6b ist eine Leuchtplatte 20 mit einem rechteckförmigen Leuchtfeld 21 vorgesehen. Die Leuchtplatte 20 liegt flächig auf einer Bodenfläche 22 eines Optikelementes 23 an. Das Optikelement 23 weist eine bogenförmige Reflexionsfläche 24 auf, die nach Art einer Freiformfläche gebildet ist, so dass eine Leuchtdichteverteilung gemäß Figur 5b erzeugt wird.

Wie aus Figur 6a und 6b zu ersehen ist, liegen die Leuchtelemente-Chips 4 relativ nah an einer bevorzugten Randwandung 25' an, so dass ein relativ großer Leuchtdichtegradient G' erzielbar ist. Dieser ermöglicht die relativ scharfe Hell-Dunkel-Grenze HDG, wobei der asymmetrische Verlauf der Hell-Dunkel-Grenze HDG (15° Anstieg) durch die bauchige Form der Reflexionsfläche 24 des Optikelementes 23 erzeugt wird.

In Figur 5b ist das Intensitätsmaximum I₂ dargestellt, das durch die vier Leuchtelemente-Chips 4 in der Breite und Form bestimmt wird. Die Intensität I₁ an der Hell-Dunkel-Grenze HDG wird bestimmt durch den starken Abfall der Leuchtdichte L₁ im Bereich der bevorzugten Randwand 25'. Der Abstand der Leuchtelemente-Chips 4 zu den weiteren Randwänden 25" ist größer gewählt, so dass die entsprechenden Leuchtdichtegradienten G" flacher ausgebildet sind. Der Abstand der Leuchtelemente-Chips 4 zu den Randwänden 25 ist ein Maß für die Steilheit des Leuchtdichteabfalls bzw. zur Größe des Leuchtdichtegradienten G.

Nach einer dritten Ausführungsform gemäß Figur 7a bis 8b ist eine Leuchtplatte 30 mit einer asymmetrisch ausgebildeten Leuchtfeld/Ausnehmung 31 vorgesehen. Das Leuchtfeld bzw. die Ausnehmung 31 werden in Übereinstimmung mit den vorhergehenden Ausführungsbeispielen durch Randwandungen 32 begrenzt, wobei eine bevorzugte Randwandung 32' eine Knickstelle 33 aufweist, von der aus sich ein Abschnitt der Randwandung 32' unter einem Winkel von 15° weiter erstreckt. An den beiden durch die Knickstelle 33 getrennten Abschnitten der Randwandung 32' liegen unmittelbar mit ihren Seitenwänden die Leuchtelemente-Chips 4 an, so dass ein großer Leuchtdichtegradient G' zur Bildung der Hell-Dunkel-Grenze HDG gebildet ist.

Wie aus Figur 7a und 7b ersichtlich, ist, ein als Linse ausgebildetes Optikelement 34, das in einem Abstand zu der Leuchtplatte 30 angeordnet ist, vorgesehen. Ein unterer Bereich L₁ des Leuchtfeldes, der entlang der bevorzugten Randwandung 32' verläuft, korrespondiert zu einem Intensitätsbereich I₁ der Lichtverteilung, an dessen Rand die Hell-Dunkel-Grenze HDG verläuft. Ein oberer Bereich L₂ des Leuchtfeldes wird in einem unteren Intensitätsbereich I₂ der auf einem im normierten Abstand angeordneten Messschirm abgebildeten Lichtverteilung abgebildet. Die Leuchtplatte 30 ist vorzugsweise in einer Brennebene der Linse 34 angeordnet.

Den vorgenannten Ausführungsbeispielen ist gemeinsam, dass der größte Bereich der Ausnehmung durch die Leuchtelemente-Chips 4 ausgefüllt wird, jedoch zur Bildung einer Hell-Dunkel-Grenze HDG der Abstand von Gruppen der Leuchtelemente-Chips 4 zu der Randkante relativ gering oder null gewählt ist. Die unterschiedlichen Geometrien der Leuchtfelder können zur Generierung unterschiedliche Lichtverteilungen, insbesondere jeweils zur Bildung von Basislicht, asymmetrischem Licht oder anderen Lichtkonfigurationen einzeln oder in Kombination eingesetzt werden. Der so gebildete Scheinwerfer kann beispielsweise zur Erzeugung einer Abblendlicht-, Fernlicht-, Autobahnlicht- und/oder Kurvenlichtfunktion dienen.

## Patentansprüche

1. Scheinwerfer für Fahrzeuge mit mindestens einem eine Mehrzahl von Leuchtelementen-Chips aufweisenden flächenhaften Leuchtfeld und mit einem sich im Strahlengang des von dem Leuchtfeld ausgesandten Lichtbündels angeordneten Optikelement, **dadurch gekennzeichnet, dass** die Leuchtelemente-Chips (4) des Leuchtfeldes (3, 21, 31) in einer gemeinsamen Ausnehmung (5) angeordnet sind und dass die Ausnehmung (5) auf einer in Lichtabstrahlrichtung (8) zugewandten Seite eine Randkante (9, 25, 32) derart in räumlicher Anordnung zu den Leuchtelementen-Chips (4) aufweist, dass ein vorgegebener Leuchtdichtegradient (G, G', G") in einer Lichtverteilung (L) des Scheinwerfers im Bereich der Randkanten (9, 25, 32) ausgebildet wird.

2. Scheinwerfer nach Anspruch 1, **dadurch gekennzeichnet, dass** die Ausnehmung (5) wannenförmig ausgebildet ist mit einer sich senkrecht zur Lichtabstrahlrichtung (8) des Leuchtfeldes (3) verlaufenden und sich von einer Bodenseite (6) der Ausnehmung (5) erhebenden Randwandung (7, 7', 7"), an deren der Bodenseite (6) abgewandten Seite die Randkante (9) verläuft.

3. Scheinwerfer nach Anspruch 1 oder 2, **dadurch gekennzeichnet, dass** die Randkante (9) umlaufend in einer Ebene verläuft, die senkrecht zur Hauptabstrahlrichtung des Leuchtfeldes (3) orientiert ist.

4. Scheinwerfer nach einem der Ansprüche 1 bis 3, **dadurch gekennzeichnet, dass** der Verlauf der Randwandung (7, 7') und/oder der Randkante (9) derart ausgebildet ist, dass in Verbindung mit dem vorgelagerten Optikelement (2, 23, 34) eine vorgegebene Leuchtdichteverteilung erzeugt wird.

5. Scheinwerfer nach einem der Ansprüche 1 bis 4 **dadurch gekennzeichnet, dass** die Randwandung (7, 7') und/oder die Randkante (9) der Ausnehmung (5) in Draufsicht rechteckförmig oder dreieckförmig oder kreisausschnittförmig verläuft und dass die Randkante (32, 32') eine Knickstelle (33) aufweist zur Bildung einer asymmetrischen Hell-Dunkel-Grenze (HDG).

6. Scheinwerfer nach einem der Ansprüche 1 bis 5, **dadurch gekennzeichnet, dass** mehrere Leuchtdioden-Chips (4) unmittelbar angrenzend zumindest an der die Hell-Dunkel-Grenze (HDG) erzeugenden Randkante (9) aufweisenden Randwandung (7, 7') angeordnet sind.

7. Scheinwerfer nach einem der Ansprüche 1 bis 6, **dadurch gekennzeichnet, dass** die Ausnehmung (5) mit einem lichtkonvertierenden Leuchtstoff aufgefüllt ist, derart, dass das von den Leuchtelementen-Chips (4) ausgesandte Licht in weißes Licht umgewandelt wird.

8. Scheinwerfer nach einem der Ansprüche 1 bis 7, **dadurch gekennzeichnet, dass** der lichtkonvertierende Leuchtstoff in einem die Ausnehmung (5) abdeckenden Vergussmaterial integriert ist.

9. Scheinwerfer nach einem der Ansprüche 1 bis 8, **dadurch gekennzeichnet, dass** die Bodenseite (6) der Ausnehmung (5) verspiegelt ausgebildet ist.

10. Scheinwerfer nach einem der Ansprüche 1 bis 9, **dadurch gekennzeichnet, dass** das Leuchtfeld (3) in einer Leuchtplatte (1) integriert ist, wobei die Ausnehmung (5) in einer senkrecht zur Lichtabstrahlrichtung (8) verlaufenden Vorderseite (10) der Leuchtplatte (1) eingefasst ist.

## Claims

1. A vehicle headlamp comprising at least one flat luminous field, having a plurality of LED chips, and an optical element which is disposed in the path of the light beam emitted by said luminous field, **characterized in that** the LED chips (4) of the luminous field (3, 21, 31) are disposed in a common recess (5), and **in that** the recess (5) has, on a side facing in direction (8) of the radiation of light, a peripheral edge (9, 25, 32) which is spatially arranged relative to the LED chips (4) in such a way that, in a light distribution (L) of the headlamp, a given luminance gradient (G, G', G") is formed in the region of the peripheral edges (9, 25, 32).

2. A headlamp according to Claim 1, **characterized in that** the recess (5) is made in the form of a trough having a boundary wall (7, 7', 7") which extends perpendicular to the direction (8) of the radiation of light from the luminous field (3) and extends upwards from the bottom (6) of the recess (5), the peripheral edge (9) being disposed on the side of the boundary wall (7, 7', 7") away from the bottom (6) of said recess (5).

3. A headlamp according to Claim 1 or 2, **characterized in that** the peripheral edge (9) is disposed in a plane which is oriented perpendicular to the main direction of the radiation of light from the luminous field (3).

4. A headlamp according to one of Claims 1 to 3, **characterized in that** the course of the boundary wall (7, 7') and/or of the peripheral edge (9) is such that, together with the optical element (2, 23, 34) disposed ahead of them, they produce a given luminance distribution.

5. A headlamp according to one of Claims 1 to 4, **characterized in that**, when viewed from above, the boundary wall (7, 7') and/or peripheral edge (9) of the recess (5) takes the form of a rectangle or triangle or segment of a circle, and **in that** the peripheral edge (32, 32') has a bend (33) for forming an asymmetrical light/dark boundary (LDB).

6. A headlamp according to one of Claims 1 to 5, **characterized in that** a plurality of LED chips (4) are disposed directly adjacent to at least the boundary wall (7, 7') having the peripheral edge (9) which produces the light/dark boundary (LDB).

7. A headlamp according to one of Claims 1 to 6, **characterized in that** the recess (5) is filled with a light-converting fluorescent substance in such a way that the light emitted by the LED chips (4) is converted into white light.

8. A headlamp according to one of Claims 1 to 7, **characterized in that** the light-converting fluorescent substance is incorporated in a sealing material which covers the recess (5).

9. A headlamp according to one of Claims 1 to 8, **characterized in that** the bottom (6) of the recess (5) is aluminium-coated by vaporization.

10. A headlamp according to one of Claims 1 to 9, **characterized in that** the luminous field (3) is incorporated into a luminous panel (1), the recess (5) being set in a front side (10) - extending perpendicular to the direction (8) of the radiation of light - of the luminous panel (1).

## Revendications

1. Projecteur pour véhicule avec au moins un champ lumineux en nappe comprenant une pluralité de puces d'éléments lumineux et avec un élément optique disposé sur la trajectoire du faisceau lumineux émis par le champ lumineux, **caractérisé en ce que** les puces d'éléments lumineux (4) du champ lumineux (3, 21, 31) sont disposées dans un évidement commun (5), et **en ce que** l'évidement (5) présente une arête de bordure (9, 25, 32) sur un côté orienté dans la direction de diffusion lumineuse (8), spatialement disposée relativement aux puces d'éléments lumineux (4) de manière à former un gradient de luminance défini (G, G', G") dans une répartition lumineuse (L) du projecteur au niveau des arêtes de bordure (9, 25, 32).

2. Projecteur selon la revendication 1, **caractérisé en ce que** l'évidement (5) est en forme d'auge, avec une paroi de bordure (7, 7', 7") s'étendant perpendiculairement à la direction de diffusion lumineuse (8) du champ lumineux (3) et s'élevant depuis une face de fond (6) de l'évidement (5), l'arête de bordure (9) s'étendant sur le côté opposé à la face de fond (6) de ladite paroi.

3. Projecteur selon la revendication 1 ou 2, **caractérisé en ce que** l'arête de bordure (9) s'étend périphériquement sur un plan orienté perpendiculairement à la direction de diffusion principale du champ lumineux (3).

4. Projecteur selon l'une des revendications 1 à 3, **caractérisé en ce que** le tracé de la paroi de bordure (7, 7') et/ou de l'arête de bordure (9) est conformé de manière à produire une répartition lumineuse définie en association avec l'élément optique (2, 23, 34) antéposé.

5. Projecteur selon l'une des revendications 1 à 4, **caractérisé en ce que** la paroi de bordure (7, 7') et/ou l'arête de bordure (9) de l'évidement (5) ont un tracé rectangulaire, triangulaire ou en arc de cercle vu du dessus, et **en ce que** l'arête de bordure (32, 32') présente un point d'inflexion (33) pour la formation d'une limite de clair-obscur (HDG) asymétrique.

6. Projecteur selon l'une des revendications 1 à 5, **caractérisé en ce que** plusieurs puces à diodes électroluminescentes (4) sont disposées immédiatement adjacentes au moins à la paroi de bordure (7, 7') comportant l'arête de bordure (9) générant la limite de clair-obscur (HDG).

7. Projecteur selon l'une des revendications 1 à 6, **caractérisé en ce que** l'évidement (5) est comblé par une substance luminescente convertisseuse de lumière, et **en ce que** la lumière émise par les puces d'éléments lumineux (4) est convertie en lumière blanche.

8. Projecteur selon l'une des revendications 1 à 7, **caractérisé en ce que** la substance luminescente convertisseuse de lumière est intégrée à un matériau d'enrobage recouvrant l'évidement (5).

9. Projecteur selon l'une des revendications 1 à 8, **caractérisé en ce que** la face de fond (6) de l'évidement (5) est réfléchissante.

10. Projecteur selon l'une des revendications 1 à 9, **caractérisé en ce que** le champ lumineux (3) est intégré à une plaque lumineuse (1), l'évidement (5) étant inclus dans une face antérieure (10) de la plaque lumineuse (1) s'étendant perpendiculairement à la direction de diffusion lumineuse (8).
